Europäisches Patentamt

(19) European Patent Office

Office européen des brevets

(11) Veröffentlichungsnummer: **0 085 338**
**B1**

(12) **EUROPÄISCHE PATENTSCHRIFT**

(45) Veröffentlichungstag der Patentschrift:
10.07.85

(21) Anmeldenummer: 83100361.1

(22) Anmeldetag: 17.01.83

(51) Int. Cl.⁴: **G 01 R 23/00,** G 06 G 7/16,
**H 02 P 5/40**

(54) **Vorrichtung zum Bestimmen der gemeinsamen Frequenz zweier unabhängig veränderlicher Wechselgrössen, insbesondere bei einer Drehfeldmaschine.**

(30) Priorität: 01.02.82 DE 3203257

(43) Veröffentlichungstag der Anmeldung:
10.08.83 Patentblatt 83/32

(45) Bekanntmachung des Hinweises auf die Patenterteilung:
10.07.85 Patentblatt 85/28

(84) Benannte Vertragsstaaten:
DE FR GB SE

(56) Entgegenhaltungen:
EP - A - 0 043 973
DE - B - 2 833 542
GB - A - 1 206 161
US - A - 3 167 649

(73) Patentinhaber: Siemens Aktiengesellschaft, Berlin und
München Wittelsbacherplatz 2, D-8000 München 2 (DE)

(72) Erfinder: Reng, Leonhard, Dipl.-Ing.,
Georg-Krauss-Strasse 8, D-8520 Erlangen (DE)

**Beschreibung**

Die Erfindung betrifft eine Vorrichtung zum Bestimmen der gemeinsamen Frequenz $\omega$ zweier zeitlich voneinander unabhängiger veränderlicher elektrischer Wechselgrößen $a_1$, $a_2$, wobei den Wechselgrößen $a_1$ und $a_2$ eine mit der Frequenz

$$\omega = \frac{d\,\alpha}{dt}$$

zeitlich veränderliche Winkelgröße $\alpha$ gemäß der Beziehung

$$\frac{a_1}{a_2} = ctg\,\alpha$$

zugeordnet ist. Die Größen $a_1$, $a_2$, $\alpha$ und $\omega$ sind also jeweils zeitabhängige Funktionen.

Bevorzugtes Anwendungsgebiet der Erfindung ist die feldorientierte Steuerung oder Regelung eines Drehfeldmaschinenantriebes. Ein derartiger Antrieb besteht aus einer von einem Umrichter gespeisten Drehfeldmaschine mit einer Vorrichtung zur Steuerung oder Regelung des Umrichters. Diese Vorrichtung benötigt einen in einer Flußbestimmungsvorrichtung bestimmbaren Winkel, der die momentane Richtung der Feldachse beschreibt (z. B. in Form zweier Wechselgrößen sin $\alpha$, cos $\alpha$, wobei $\alpha$ der Winkel zwischen der Feldachse und einer Ständerwicklungsachse oder Läuferachse sein kann). Ferner sind Sollwerte eingegeben, die die zur Feldachse parallele und dazu senkrechte Komponente der Ständerdurchflutung bzw. des Ständerstromes festlegen. Mit der feldparallelen Komponente kann die Stärke des Feldes auf einen für die Ausnutzung von Umrichter und Drehfeldmaschine optimalen (insbesondere konstanten) Wert eingestellt werden, während unabhängig davon mit der feldparallelen Komponente das Drehmoment bzw. die Drehzahl entsprechend den Anforderungen an den Antrieb eingestellt werden kann.

Ein derartiger Antrieb ist in der DE-C-2 833 542 oder der DE-A-3 026 202 beschrieben, wobei dort die Flußbestimmungseinrichtung aus Ständerströmen und Ständerspannungen zunächst zwei elektrische Größen ermittelt, die der EMK der Maschine zugeordnet sind. Durch Integration werden elektrische Größen bestimmt, durch die das Feld hinsichtlich des obenerwähnten Winkels $\alpha$ sowie des Feldbetrages festgelegt ist. Diese Flußbestimmungsvorrichtung verwendet die momentane Betriebsfrequenz, um durch Einstellung eines frequenzabhängigen Verstärkungsparameters eine Adaption an den jeweiligen Betriebszustand und letztlich bei jeder Betriebsfrequenz eine optimale Bedämpfung störender Oberschwingungen zu erreichen. Auch an anderen Stellen des Maschinenantriebs kann vorteilhaft eine Anpassung an die jeweilige Betriebsfrequenz vorgenommen werden. Im stationären Fall ist z. B. die Betriebsfrequenz einer Synchronmaschine gleich der Frequenz des umlaufenden Feldes, so daß die Maschinenfrequenz gelegentlich selbst da verwendet wurde, wo besser die Frequenz des umlaufenden Feldes verwendet würde.

Auch die resultierende elektrische Durchflutung des Ständers, die aus den Strömen in den einzelnen Ständerwicklungen zusammengesetzt werden kann bzw. der resultierende Ständerstrom ist mit zwei Größen $a_1$ und $a_2$ darstellbar, die den Winkel der Durchflutungsachsen bezüglich einer raumfesten Achse, z. B. einer Ständerwicklung, festlegen. Durch die zeitabhängige Größe

$$C = \sqrt{a_1{}^2 + a_2{}^2}$$

ist dabei auch die Größe der elektrischen Durchflutung bestimmt. Dadurch kann z. B. die Soll-Richtung $\alpha^*$ des Ständerstromes aus zwei Sollwerten $a_1{}^*$, $a_2{}^*$ für den Ständerstrom gebildet werden, die aus den erwähnten Sollwerten für die feldparallele und feldsenkrechte Ständerstromkomponente abgeleitet sind und gemäß

$$i_a^* = a_1\,,$$

$$i_b^* = -\frac{1}{2}a_1 + \frac{\sqrt{3}}{2}a_2\,,$$

$$i_c^* = -\frac{1}{2}a_1 - \frac{\sqrt{3}}{2}a_2$$

in die Sollwerte $i_a{}^*$, $i_b{}^*$, $i_c{}^*$ für die Ständerwicklungsströme umgerechnet werden können, oder es kann der Ist-Ständerstrom durch zwei Wechselgrößen $a_1$, $a_2$ beschrieben werden, die aus zwei Ständerwicklungs-Istwerten durch Umkehrung dieser Beziehungen gewonnen sind.

Auch in diesem Fall kann es vorteilhaft sein, die Richtungsänderung der Gesamtdurchflutung, das heißt die Frequenz, mit der sich z. B. der Winkel zwischen Ständerstrom und raumfester Bezugsachse, Läuferachse oder Feldachse ändert, aus vorgegebenen oder meßtechnisch zugänglichen Wechselgrößen $a_1$ und $a_2$ zu bestimmen. Da die feldparallele und feldsenkrechte Stromkomponente beim feldorientierten Betrieb unabhängig voneinander vorgegeben werden, sind auch die Wechselgrößen $a_1$ und $a_2$ entsprechend veränderlich; die Frequenz $\omega = d\,\alpha/dt$ hängt daher nicht nur von einer Wechselgröße und deren zeitlicher Änderung ab, sondern auch von der anderen Wechselgröße (oder der Betragsgröße c) und deren Änderung. Aufgrund dieser Abhängigkeiten ist zu erwarten, daß sich die Berechnung der Änderungsfrequenz des Winkels $\alpha$ nur mittels verhältnismäßig hohen apparativen Aufwandes möglich ist.

Die Bestimmung der Richtungsänderung (z. B. Umlauffrequenz bezüglich der Läuferachse) des Feldes und der elektrischen Ständerdurchflu tung einer Drehfeldmaschine sind lediglich zwei augenfällige Anwendungen für die in der Drehstromtechnik häufigere Aufgabe, aus zwei Wechselgrößen $a_1$ und $a_2$, die über eine mit der Frequenz $\omega$ veränderliche Winkelgröße $\alpha$ (z. B. einer Phasendifferenz) entsprechend der Beziehung

$$\frac{a_1}{a_2} = \mathrm{ctg}\,\alpha$$

voneinander abhängen, die Frequenz $\omega$ zu ermitteln.

Obwohl diese Frequenz $\omega$ von den Wechselgrößen selbst und auch von deren zeitlichen Änderungen abhängen, wie bereits erwähnt wurde, soll bei der Schaltung zur Bestimmung der Frequenz auf die Verwendung von Differenzierern verzichtet werden, da Differenziationsschaltungen nur einen begrenzten Rechenbereich besitzen, der bei stark oberschwingungsbehafteten oder nahezu sprunghaft veränderlichen Eingangsgrößen rasch überschritten wird. Außerdem bringen Differentiationsschaltungen zwangsläufig Phasenfehler mit sich, die insbesondere bei höheren Winkelgeschwindigkeiten zu störenden Rechenfehlern führen.

Diese Forderungen werden gemäß der Erfindung von einer Schaltung erfüllt, bei der die Wechselgrößen jeweils einem Glättungsglied mit dem gleichen Übertragungsverhalten zugeführt sind und daß die Wechselgrößen $a_1$ und $a_2$ und die Ausgangsgrößen $d_1$, $d_2$ der beiden Glättungsglieder einer Rechenschaltung aufgeschaltet sind, an deren Ausgang die Größe

$$(d_1 \cdot a_2 - d_2 \cdot a_1)/(d_1 \cdot a_1 + d_2 \cdot a_2)$$

als der Frequenz proportionaler Wert abgegriffen ist. Das Rechenwerk ist vorteilhaft nur aus Multiplizierern, Additionsgliedern und einem oder mehreren Dividierern aufgebaut. Bevorzugt sind die Wechselgrößen $a_1$, $a_2$ den Glättungsgliedern und dem Rechenwerk als normierte Größen über eine Normierungsschaltung aufgeschaltet, die aus den Wechselgrößen normierte Wechselgrößen

$$a_{1_0} = a_1 / \sqrt{a_1^2 + a_2^2}, \quad a_{2_0} = a_2 / \sqrt{a_1^2 + a_2^2}$$

bildet.

Die Schaltung nach der Erfindung sowie ihre vorteilhafte Anwendung bei einem Drehfeldmaschinenantrieb sind anhand von drei Figuren näher erläutert.

Fig. 1 zeigt den zeitlichen Verlauf zweier elektrischer Wechselgrößen, denen zu jedem Zeitpunkt eine beiden Wechselgrößen gemeinsame Winkelgröße $\alpha$ durch die Beziehung $a_1/a_2$ $= \mathrm{ctg}\,\alpha$ zugeordnet ist, wobei bei dem gezeigten Verlauf der Winkelgrößen die gemeinsame Frequenz $\omega = d\,\alpha/dt$ zugeordnet ist.

Fig. 2 zeigt eine Vorrichtung gemäß der Erfindung zur Bestimmung dieser Frequenz $\omega$.

Fig. 3 stellt schematisch eine Vorrichtung zur Steuerung einer Drehfeldmaschine unter Verwendung der erfindungsgemäßen Schaltung dar.

Zur Verdeutlichung der Verhältnisse sei angenommen, die gemeinsame Frequenz $\omega$ sei konstant, so daß die Winkelgröße $\alpha$ eine lineare Funktion $\alpha = \omega \cdot t$ der Zeit t ist und die Winkelgrößen gemäß

$$\frac{\alpha_1}{\cos \alpha} = \frac{a_2}{\sin \alpha} = \frac{a_2}{\cos(\alpha - \pi/2)} = c$$

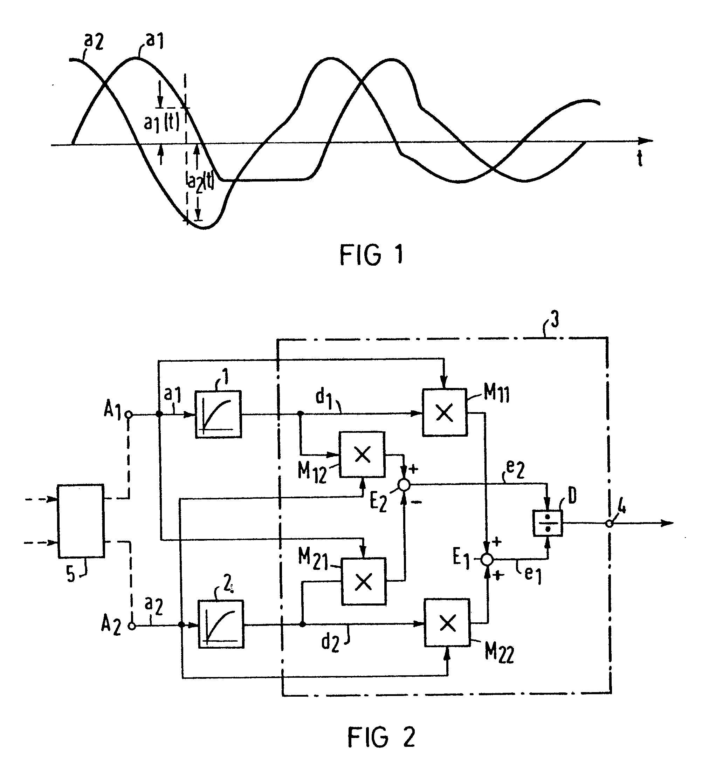

durch eine zeitabhängige Größe c bestimmt sind. Dies ist in Fig. 1 dargestellt, wobei c in der ersten Halbwelle von $a_1$ einen konsanten (höheren) Wert und in der zweiten Halbwelle vorübergehend einen kleineren Wert annimmt. In der dritten Halbwelle findet ein Übergang auf einen geringeren Wert von c statt, der in der vierten Halbwelle beibehalten wird.

Derartige Verhältnisse liegen z. B. bei einer Drehfeldmaschine vor, wobei c die Stärke und $\omega$ die Umlauffrequenz des magnetischen Feldes darstellt, während die Wechselgrößen $a_1$ und $a_2$ z. B. die Hallspannungen zweier am Umfang der Ständerwicklung um 90° gegeneinander versetzter Sonden sind. An Stelle der Hallspannungen können zur Erfassung des magnetischen Drehfeldes auch simulierte Spannungen verwendet werden, die aus den Ständerspannungen und -strömen abgeleitet werden. Der Winkel $\alpha$ entspricht dabei dem Winkel zwischen der magnetischen Feldachse und einer ständerbezogenen Bezugsachse. Fig. 1 macht deutlich, daß die Veränderung des Winkels $\alpha$ aus dem Verlauf der Wechselgrößen $a_1$, $a_2$ nicht ohne weiteres ersichtlich ist, selbst wenn $\omega = d\,\alpha/dt$ konstant ist. Im allgemeinen Fall ergeben sich noch unübersichtlichere Verhältnisse, bei denen aber immer noch den Wechselgrößen $a_1$ und $a_2$ eine gemeinsame Frequenz zugeschrieben werden kann.

Zur Bestimmung der jeweiligen Momentanwerte dieser gemeinsamen Frequenz $\omega$ dient die Schaltung nach Fig. 2, deren Eingängen A1, A2 die Wechselgrößen $a_1$, $a_2$ zugeführt werden. Für jede Wechselgröße ist ein Glättungsglied 1 bzw. 2 vorgesehen, die ein gleiches Übergangsverhalten haben (Verzögerungsglieder erster Ordnung, Übergangsfunktion V/(1 + sT) mit der Proportionalverstärkung V und der Zeitkonstanten T). Die Ausgangsgrößen $d_1$ und $d_2$ der beiden Glättungsglieder sind jeweils ersten Multiplizierern M11 und M22 in der Rechenschaltung 3 zugeführt, um die Produkte $a_1 \cdot d_1$ und $a_2 \cdot d_2$ zu bilden. Die Ausgangssignale beider Multiplizierer sind einer ersten Additionsstelle $E_1$ zugeführt, an deren Ausgang nunmehr die Größe

$$e_1 = d_1 \cdot a_1 + d_2 \cdot a_2$$

ansteht. Ferner sind in der Rechenschaltung 3 zwei weitere Multiplizierer M12 und M21 zur Bil-

dung der Produkte $d_1 \cdot a_2$ und $d_2 \cdot a_1$ vorgesehen, deren Ausgänge einer zweiten Additionsstelle E2 zugeführt sind, an deren Ausgang nunmehr die Größe

$$e_2 = d_1 \cdot a_2 - d_2 \cdot a_1$$

anliegt. Ein Dividierer D bildet aus den Ausgangssignalen der beiden Additionsstellen den Quotienten $e_2/e_1$, der am Ausgang 4 der Rechenschaltung abgegriffen werden kann und direkt proportional der gewünschten Frequenz $\omega$ ist. Es zeigt sich, daß die Proportionalitätskonstante gleich der Zeitkonstante der Glättungsglieder 1 bzw. 2 ist.

Fig. 2 stellt den Aufbau der Rechenschaltung 3 aus vier Multiplizierern, zwei Additionsgliedern und einen Dividierer dar. Die mathematischen Operationen können auch in anderer Reihenfolge (unter Umständen unter Verwendung mehrerer Dividierer) durchgeführt werden, um den der gewünchten Frequenz proportionalen Quotienten zu erhalten. Wesentlich ist, daß hierfür nur statische Rechenglieder verwendet werden, d. h. Rechenglieder, deren Ausgangsgrößen Momentanwerte darstellen, die nur von den Momentanwerten der Eingangsgrößen abhängen, also kein frequenz- und zeitabhängiges Übergangsverhalten aufweisen.

Die Amplituden der Ausgangsgrößen der Additionsglieder E1 und E2 werden um so kleiner, je kleiner $(a_1^2 + a_2^2)$ wird, was für die Genauigkeit und den Rechenbereich des Dividierers D von Bedeutung werden kann. Daher ist es vorteilhaft, wenn den Eingängen A1, A2 eine Normierungsschaltung 5 vorgeordnet ist, die die Wechselgrößen $a_1$ und $a_2$ in entsprechend normierte Wechselgrößen

$$a_1/\sqrt{a_1^2 + a_2^2} \quad \text{und} \quad a_2/\sqrt{a_1^2 + a_2^2}$$

umrechnet. Diese normierten Wechselgrößen werden nun den Glättungsgliedern und der Rechenschaltung zugeführt, ohne daß sich dabei am Wert der am Ausgang 4 abgreifbaren Frequenz etwas ändert.

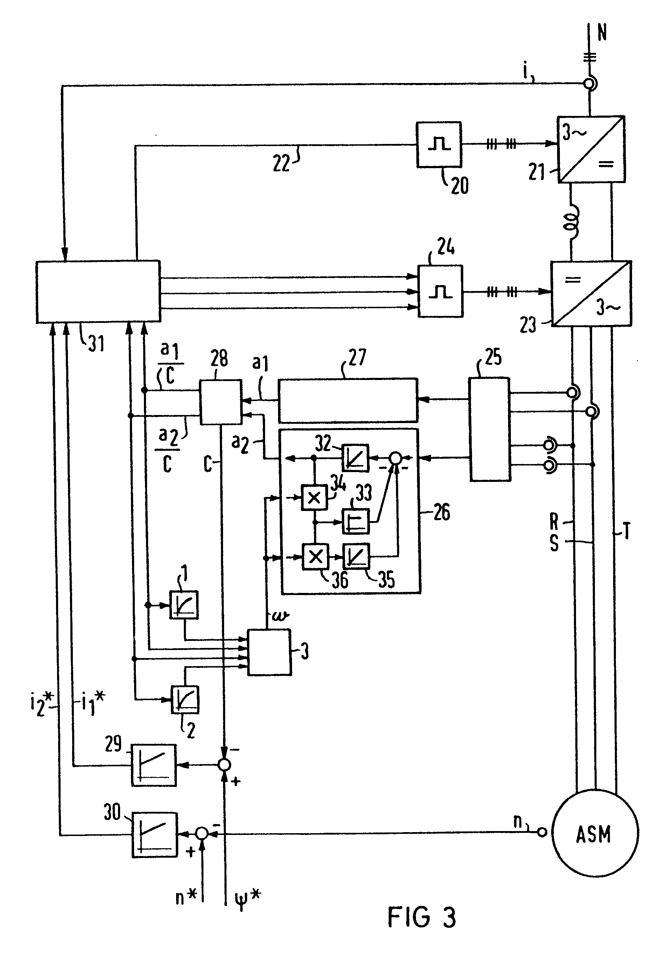

Die Vorrichtung nach der Erfindung kann beispielsweise in einem Drehfeldmaschinenantrieb verwendet werden, wie er in Fig. 3 gezeigt ist. Er besteht aus einem Umrichter, einer Drehfeldmaschine, beispielsweise einer Asynchronmaschine, einer Flußbestimmungsvorrichtung und einer Umrichtersteuerung.

Der Umrichter kann z. B. einen Zwischenkreis mit eingeprägtem Gleichstrom enthalten. Über einen Steuersatz 20 wird der netzseitige Gleichrichter 21 so geregelt, daß der Zwischenkreisstrom einen über die Leitung 22 eingegebenen, dem gewünchten Betrag der Ständerdurchflutung der Asynchronmaschine entsprechenden Sollwert einnimmt.

Der lastseitige Wechselrichter 23 wird vom entsprechenden Steuersatz 24 so gesteuert, daß der Zwischenkreisstrom auf die drei Ausgänge R, S, T und die daran angeschlossenen Wicklungen des Ständers derart verteilt werden, daß sich in dem Ständer eine vorgegebene Richtung für die Ständerdurchflutung ergibt.

Der Flußbestimmungsvorrichtung sind Istwerte für Ständerstrom und Ständerspannung zugeführt. Diese Istwerte sind über entsprechende Meßwandler an den Eingängen der Drehfeldmaschine abgegriffen. Daraus werden in einem EMK-Detektor 25 zwei Größen gebildet, die die EMK der Maschine hinsichtlich Betrag und Richtung erfassen, wie z. B. in der DE-A-3 034 275 beschrieben ist. Jede dieser elektrischen Größen wird einem Wechselspannungsintegrator 26, 27 zugeführt, der durch Integration daraus die Wechselgrößen $a_1$ und $a_2$ bildet, die das Feld der Maschine in Betrag und Richtung bestimmen. Anschließend werden diese Wechselgrößen in der Normierungsschaltung 28, die die Normierungsgröße

$$c = \sqrt{a_1^2 + a_2^2}$$

bildet, in entsprechend normierte Wechselgrößen $a_1/c$, $a_2/c$ umgerechnet, wobei diese normierten Wechselgrößen nunmehr die Richtung des Feldes in der Maschine beschreiben.

Zur Steuerung der Maschine wird aus der Normierungsgröße c und einem Sollwert $\psi^*$ für den Betrag des Feldes eine Regelabweichung gebildet, die einem entsprechenden Regler 29 zugeführt wird, der daraus einen Sollwert $i_1^*$ bildet. Ein zweiter Sollwert $i_2^*$ wird z. B. von einem Regler 30 gebildet, dem die Regelabweichung zwischen der Drehzahl n der Maschine und einem vorgegebenen Drehzahlsollwert $n^*$ zugeführt ist. Die beiden Sollwerte $i_1^*$ und $i_2^*$ legen die Ständerdurchflutung in ihrem Betrag und Richtung (bezogen auf die Feldachse) fest.

Aus diesen beiden Sollwerten und den die Feldrichtung bestimmenden normierten Wechselgrößen ermittelt die Steuereinrichtung 31 einerseits den gewünschten Betrag des Ständerstromes, der für den Steuersatz 20 benötigt wird, andererseits die Aufteilung des Ständerstromes auf die drei Stromzuleitungen R, S, T der Asynchronmaschine, die vom Steuersatz 24 benötigt wird.

Die zur Flußbestimmung benötigten Wechselspannungsintegratoren 26 und 27 sind so aufgebaut, daß sie eine Nullpunktsdrift unterdrücken. Dazu wird jede elektrische Ausgangsgröße des EMK-Detektors jeweils einem Integrator 32 zugeführt, dessen Ausgangsgröße, nämlich die Wechselgröße $a_2$, über eine Rückführungsleitung mit einer Nullpunktregelschaltung zum Integratoreingang zurückgeführt ist. Diese Nullpunktregelschaltung enthält einen p-Regler 33, dem über einen Multiplizierer die entsprechende Wechselgröße, verstärkt mit einem von der Frequenz $\omega$ des Feldes abhängigen Faktor zugeführt ist. Ferner ist ein I-Regler 35 vorgesehen, dem über einen anderen Multiplizierer 36 die Wechselgröße, verstärkt um einen weiteren, von der Frequenz $\omega$ abhängigen Faktor, zugeführt ist. Beide Reglerausgänge sind dem Integratoreingang aufgeschaltet. Es kann aber auch vorgesehen sein, dem Integratoreingang weitere Größen aufzuschalten, wie dies in der DE-A-3 026 202 beschrieben ist.

Durch die frequenzabhängigen Faktoren in der Nullpunktregelschaltung kann nun nicht nur erreicht werden, daß eine Nullpunktsdrift der Integratoren unterdrückt wird, vielmehr kann ein Integratorfehler in dem gesamten Frequenzbereich nahezu völlig vermieden werden. Insbesondere kann damit auch der gesamte Antrieb jeweils mit einer optimalen, an den jeweiligen Betriebszustand adaptierten Weise bedämpft werden.

Zur Ermittlung der Frequenz $\omega$ des Feldes wird die erfindungsgemäße Vorrichtung eingesetzt, wobei bereits ausgenutzt werden kann, daß bei dem bisher beschriebenen Aufbau des Antriebes neben den Wechselgrößen $a_1$, $a_2$ auch die normierten Wechselgrößen $a_1/c$, $a_2/c$ zur Verfügung stehen. Es erübrigt sich also die in Fig. 2 gezeigte Normierschaltung, vielmehr werden die normierten Wechselgrößen den Glättungsgliedern 1, 2 und der Rechenschaltung 3 zugeführt, um die Frequenz $\omega$ des Feldes zu ermitteln.

## Patentansprüche

1. Vorrichtung zum Bestimmen der gemeinsamen Frequenz $\omega$ zweier zeitlich voneinander unabhängig veränderlicher elektrischer Wechselgrößen $a_1$, $a_2$, wobei den Wechselgrößen $a_1$ und $a_2$ eine mit der Frequenz

$$\omega = \frac{d\alpha}{dt}$$

zeitlich veränderliche Winkelgröße $\alpha$ gemäß der Beziehung

$$a_1/a_2 = \text{ctg } \alpha$$

zugeordnet ist, dadurch gekennzeichnet, daß die Wechselgrößen jeweils einem Glättungsglied (1, 2) mit dem gleichen Übertragungsverhalten zugeführt sind und daß die Wechselgrößen $a_1$ und $a_2$ und die Ausgangsgrößen $d_1$, $d_2$ der beiden Glättungsglieder (1, 2) einer Rechenschaltung (3) aufgeschaltet sind, an deren Ausgang die Größe

$$(d_1 \cdot a_2 - d_2 \cdot a_1)/(d_1 \cdot a_1 + d_2 \cdot a_2)$$

als der Frequenz $\omega$ proportionaler Wert abgegriffen ist.

2. Vorrichtung nach Anspruch 1, dadurch gekennzeichnet, daß die Rechenschaltung nur aus Additionsgliedern (E1, E2), Multiplizierern (M11, M12, M21, M22) und einem oder mehreren Dividierern (D) aufgebaut ist.

3. Vorrichtung nach Anspruch 1 oder 2, dadurch gekennzeichnet, daß die elektrischen Wechselgrößen $a_1$, $a_2$ den Glättungsgliedern (1, 2) und der Rechenschaltung (3) über eine Normierungsschaltung (5) zugeführt sind, die die

elektrischen Wechselgrößen $a_1$, $a_2$ in normierte Wechselgrößen

$$a_{1_0} = a_1/\sqrt{a_1^2 + a_2^2} \quad \text{und} \quad a_{2_0} = a_2/\sqrt{a_1^2 + a_2^2}$$

umsetzt.

4. Verwendung der Vorrichtung nach einem der Ansprüche 1 bis 3, bei einem Drehfeldmaschinenantrieb mit einer Steuer- oder Regeleinrichtung, die aus Meß- oder Steuergrößen zwei den orthogonalen Komponenten der Ständerdurchflutung oder einer anderen umlaufenden Maschinengröße, insbesondere des Flusses, entsprechende zeitlich veränderliche Wechselgrößen bildet und mit der aus den Wechselgrößen bestimmten Frequenz in die Steuerung oder Regelung der Maschine eingreift.

## Claims

1. A device for determining the common frequency $\omega$ of two electrical alternating quantities $a_1$, $a_2$ which are variable with time independently of one another, wherein the alternating quantities $a_1$ and $a_2$ are assigned an angular quantity which is variable with time with the frequency

$$\omega = \frac{d\alpha}{dt}$$

in accordance with the equation $a_1/a_2 = \text{ctg } \alpha$, characterised in that the alternating quantities are respectively fed to a smoothing element (1, 2) having the same transmission behaviour and that the alternating quantities $a_1$ and $a_2$ and the output quantities $d_1$, $d_2$ of the two smoothing elements (1, 2) are superimposed upon a calculating circuit (3), at whose output the quantities

$$(d_1 \cdot a_2 - d_2 \cdot a_1)/(d_1 \cdot a_1 + d_2 \cdot a_2)$$

is tapped as the value which is proportional to the frequency.

2. A device as claimed in claim 1, characterised in that the calculating circuit is only constructed of addition elements (E1, E2), multipliers (M11, M12, M21, M22) and one or more dividers (D).

3. A device as claimed in claim 1 or 2, characterised in that the electrical alternating quantities $a_1$, $a_2$ are fed to the smoothing elements (1, 2) and the calculating circuit (3) by means of a standardisation circuit (5) which converts the electric alternating quantities $a_1$, $a_2$ into standardised alternating quantities

$$a_{1_0} = a_1/\sqrt{a_1^2 + a_2^2} \quad \text{and} \quad a_{2_0} = a_2/\sqrt{a_1^2 + a_2^2}$$

4. Use of the device as claimed in one of claims 1 to 3, in a rotating field machine drive having a control or regulating device which from measuring or control quantities forms two time-variable alternating quantities which correspond to the orthogonal components of the stator flow or of another circulating machine quantity in particular of the flow, and interferes with the control or regulation of the machine with the frequency determined from the alternating quantities.

**Revendications**

1. Dispositif pour déterminer la fréquence commune de deux grandeurs alternatives électriques variables dans le temps d'une manière indépendante l'une de l'autre $a_1$, $a_2$, auxquelles est associée une grandeur angulaire $\alpha$, variable dans le temps avec la fréquence

$$\omega = d\,\alpha/dt,$$

conformément à la relation $a_1/a_2 = \cotg\,\alpha$, caractérisé par le fait que les grandeurs alternatives sont envoyées à des organes de filtrage respectifs (1, 2) possédant le même comportement de transfert, et que les grandeurs alternatives $a_1$ et $a_2$ et les grandeurs de sortie $d_1$, $d_2$ des deux organes de filtrage (1, 2) sont appliquées à un circuit de calcul (3), à la sortie duquel est prélevée la grandeur

$$(d_1 \cdot a_2 - d_2 \cdot a_1)/(d_1 - a_1 + d_2 \cdot a_2)$$

en tant que valeur proportionnelle à la fréquence $\omega$.

2. Dispositif suivant la revendication 1, caractérisé par le fait que le circuit de calcul est constitué uniquement par des circuits additionneurs (E1, E2), des multiplicateurs (M11, M12, M21, M22) et un ou plusieurs diviseurs (D).

3. Dispositif suivant la revendication 1 ou 2, caractérisé par le fait que les grandeurs alternatives électriques $a_1$, $a_2$ sont envoyées aux organes de filtrage (1, 2) et au circuit de calcul (3) par l'intermédiaire d'un circuit de normalisation (5), qui convertit les grandeurs alternatives électriques $a_1$, $a_2$ en des grandeurs alternatives normalisées

$$a_{1_0} = a_1/\sqrt{a_1^2 + a_2^2} \quad \text{et} \quad a_{2_0} = a_2/\sqrt{a_1^2 + a_2^2}$$

4. Application du dispositif suivant l'une des revendications 1 à 3, dans le cas d'un dispositif de commande d'une machine à champ tournant comportant un dispositif de commande ou de réglage qui, à partir de grandeurs de mesure ou de commande, forme deux grandeurs alternatives variables dans le temps correspondant aux deux composantes orthogonales du flux statorique ou d'une autre grandeur tournante de la machine, notamment du flux, et réalise la commande ou le réglage de la machine à l'aide de la fréquence déterminée à partir des grandeurs alternatives.

FIG 1

FIG 2

FIG 3